Europäisches Patentamt

European Patent Office

Office européen des brevets

(11) Veröffentlichungsnummer: **0 244 867 B1**

## (12) EUROPÄISCHE PATENTSCHRIFT

(45) Veröffentlichungstag der Patentschrift: **11.09.91**

(21) Anmeldenummer: **87106664.3**

(22) Anmeldetag: **07.05.87**

(51) Int. Cl.5: **B01D 9/00**, B01D 9/02, C30B 7/00, C30B 35/00

(54) Verfahren und Vorrichtung zur Auskristallisation einer in einer Flüssigkeit gelösten Substanz im Zustand der Schwerelosigkeit.

(30) Priorität: **07.05.86 DE 3615541**

(43) Veröffentlichungstag der Anmeldung:
**11.11.87 Patentblatt  87/46**

(45) Bekanntmachung des Hinweises auf die Patenterteilung:
**11.09.91 Patentblatt  91/37**

(84) Benannte Vertragsstaaten:
**CH DE FR GB IT LI NL**

(56) Entgegenhaltungen:
EP-A- 0 070 760
US-A- 4 046 617

THE UNIVERSITY OF ALABAMA AT BIRMING-HAM, COMPREHENSIVE CANCER CENTER, MISSION RESULTS REPORT, CONTRACT NUMBER NAS 8-36611, 17. Oktober 1985, Seite 7, Birmingham, Alabama, USA; C.E. BUGG:"Protein crystal growth results from shuttle flight 51-F"

(73) Patentinhaber: **Messerschmitt-Bölkow-Blohm Gesellschaft mit beschränkter Haftung Robert-Koch-Strasse W-8012 Ottobrunn(DE)**

(72) Erfinder: **Littke, Walter, Dr. Lindenstrasse 8 W-7801 Schallstadt(DE)**
Erfinder: **Schoen, Erhard Burgstrasse 20 W-8152 Vagen(DE)**

**Beschreibung**

Die Erfindung betrifft ein Verfahren zur Auskristallisation einer Substanz, die in einer im Zustand der Schwerelosigkeit befindlichen Flüssigkeit gelöst ist, sowie eine Vorrichtung zur Durchführung des Verfahrens.

Sowohl in der anorganischen und organischen Chemie als auch in der Materialforschung und der Werkstoffkunde werden oft Substanzen in der Form möglichst reiner Einkristalle benötigt, und zwar etwa zu Zwecken der Strukturuntersuchung mittels Röntgenbeugung oder zur Ermittlung sonstiger Eigenschaften der reinen kristallinen Substanzen. Es hat sich bereits herausgestellt, daß die Herstellung derartiger Einkristalle durch Auskristallisieren der entsprechenden Substanzen aus einer diese zunächst gelöst enthaltenden Flüssigkeit unter terrestrischen Gravitationsbedingungen zu schlechteren Ergebnissen führt als im gravitationsfreien Raum. Daher wurden im Weltraum, etwa im Spacelab, bereits Kristallisationsversuche durchgeführt, wobei sich die die auszukristallisierende Substanz enthaltende Flüssigkeit im Zustand der Schwerelosigkeit befand bzw. Mikrogravitationsbedingungen unterlag. Hierbei befand sich die Flüssigkeit in einem Behälter, welcher während der Durchführung des Auskristallisationsvorganges geschlossen war. Prinzipiell können unter diesen Bedingungen Kristallisationsmethoden verwendet werden, welche an sich bereits im terrestrischen Bereich erprobt sind, beispielsweise Variation der Temperatur, Änderung der Konzentrationsverhältnisse innerhalb der Flüssigkeit usw.. Bei den bereits im schwebenden Zustand durchgeführten Kristallisationsversuchen hat sich nun gezeigt, daß auch hier trotz merklicher Verbesserungen gegenüber unter terrestrischen Bedingungen auskristallisierten Einkristallen noch immer in einem gewissen Ausmaße Strukturfehler auftreten.

Der Erfindung liegt daher die Aufgabe zugrunde ein Verfahren sowie eine Vorrichtung der eingangs genannten Art bereit zu stellen, mit deren Hilfe das Ausmaß der in den auskristallisierten Einkristallen auftretenden Strukturfehler so weitgehend wie möglich vermindert werden kann.

Diese Aufgabe wird gemäß der Erfindung dadurch gelöst, daß die Flüssigkeit während der Auskristallisation als quasi freischwebende Flüssigkeitskugel gehalten und die Substanz in der Flüssigkeit mit Hilfe an sich bekannter Methoden auskristallisiert wird.

Die mit Hilfe des erfindungsgemäßen Verfahrens erzielten Verbesserungen hinsichtlich der Strukturfehlerdichte lassen sich dahingehend interpretieren, daß die quasi freischwebende Flüssigkeitskugel keinen großflächigen Wandkontakt mehr aufweist, wie dies bei herkömmlichen und einschlägig bekannten Verfahren der Fall war. Ein sehr großflächiger Wandkontakt führt vermutlich dazu, daß dort besonders häufig Kristalle anwachsen, da eine Wand kristallisationskeimbegünsigend wirkt. Eine unregelmäßige Wandoberfläche zwingt einem sich bildendem Kristall praktisch von Anfang an Strukturdefekte auf, die sich in dessen Innerem nur langsam oder gar nicht auswachsen. Dem könnte zunächst durch eine Verwendung von Kristallisationsbehältern begegnet werden, welche bis in den atomaren Bereich hinein äußerst glatte Innenwände aufweisen. Eine Herstellung derartiger Behälter ist jedoch fertigungstechnisch bis heute noch nicht möglich.

Aus dieser Problematik weist die Erfindung den Ausweg, und zwar auf einen Wandkontakt der Flüssigkeit gänzlich zu verzichten und diese vielmehr im gravitationsfreien Raum quasi frei schweben zu lassen. Der Begriff "quasi" bedeutet hier, daß selbstverständlich auf geeignete Weise dafür Sorge zu tragen ist, daß die Flüssigkeitskugel innerhalb eines vorbestimmbaren Raumbereiches gehalten wird. Dieser wird zweckmäßig von außen her durch mit Abstand zueinander angeordnete Rückhalteelemente begrenzt.

Eine Vorrichtung zur Durchführung des erfindungsgemäßen Verfahrens zeichnet sich dadurch aus, daß den Raumbereich von außen her punktuell oder linienförmig begrenzende mit Abstand zueinander angeordnete Rückhalteelemente vorhanden sind, wobei die Abstände jeweils einander benachbarter Rückhalteelemente an der Grenze des Raumbereiches kleiner sind als der Durchmmesser der Flüssigkeitskugel.

Eine Vorrichtung, die durch das Vorhandensein derartiger Rückhalteelemente gekennzeichnet ist, kann im übrigen ganz allgemein zum Festhalten einer im Zustand der Schwerelosigkeit befindlichen, schwebenden Flüssigkeitskugel innerhalb eines bestimmten Raumbereiches verwendet werden. Als unmittelbarer Zweck einer derartigen Vorrichtung kommt nicht nur die Auskristallisation von innerhalb der Flüssigkeitskugel gelösten Substanzen infrage, sondern es können in einer solchen Flüssigkeitskugel auch andere physikalisch-chemische oder rein chemische Vorgänge ablaufen bzw. durchgeführt werden.

Eine solche Vorrichtung kann ganz allgemein dort angewendet werden, wo im schwerelosen Zustand in einer Flüssigkeit sich abspielende Vorgänge oder Reaktionen zu untersuchen sind, welche möglichst ohne jede äußere Beeinflussung bleiben sollen, wie sie durch einen großflächigen Kontakt zustandekommen könnten. Ein derartiger Wandkontakt kann beispielsweise zum Einbringen von Verunreinigungen in die Flüssigkeit führen oder etwa chemische Reaktionen im Wandbereich in unerwünschter Weise beeinflussen.

Die Rückhalteelemente sind so ausgebildet sein, daß diese den Raumbereich, in dem die schwebende Flüssigkeitskugel gehalten werden soll, punktuell oder linienförmig begrenzen. Im ersteren Fall können die Rückhalteelemente in etwa radial auf die Mitte des Raumbereiches hin ausgerichtete Stifte sein. Im zweiten Fall kommen als Rückhalteelemente beispielsweise vom Inneren des Raumbereiches her gesehen konkav gewölbte Leisten oder Platten mit konkav gewölbten Kanten infrage. Außerdem sind im letzteren Fall auch gitter- oder netzartig angeordnete Drähte oder Fäden als Rückhalteelemente verwendbar, wobei diese beispielweise als korbartige oder kugelförmige Behältnisse ausgebildet sein können. Besonders vorteilhaft wirkt sich aus, wenn die Rückhalteelemente zumindest an ihrem dem Raumbereich zugekehrten Seiten aus einem durch die Flüssigkeit nicht oder nur wenig benetzbaren Material hergestellt sind.

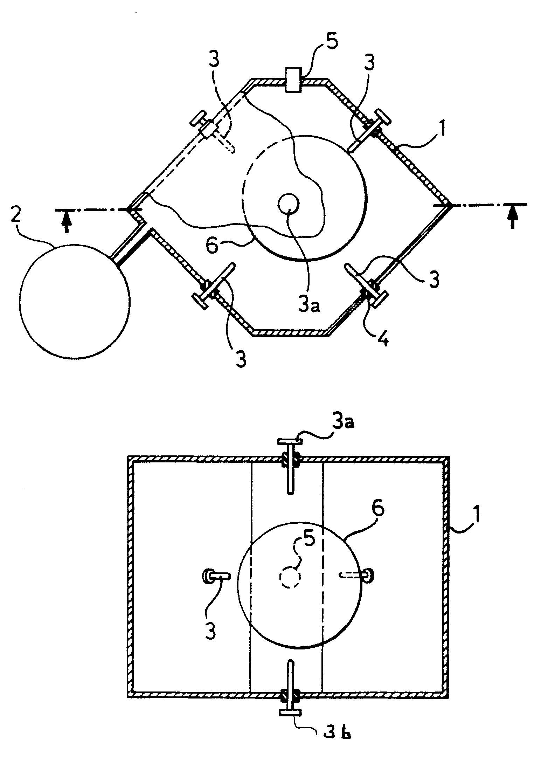

Im folgenden wird die Erfindung anhand eines in der Zeichnung dargestellten Ausführungsbeispiels näher erläutert.

Die beiden Teilfiguren der Abbildung zeigen in schematischer Weise eine Vorrichtung zur Durchführung des erfindungsgemäßen Verfahrens, nämlich einen Behälter 1 in zwei senkrecht zueinander orientierten Querschnitten, an den eine Vakuumpumpe 2 angeschlossen ist. An den Wänden des Behälters 1 sind Rückhalteelemente in Form von Stiften 3 angebracht, und zwar sind diese Stifte 3 durch Dichtungen 4 justierbar, z.B. verschieb- oder verschraubbar, hindurchgeführt. Der Behälter 1 ist in der oberen Teilfigur in Draufsicht in einem in der Ebene von vier Stiften 3 liegenden Teilquerschnitt dargestellt. Insgesamt sind sechs Stifte 3 vorhanden, von denen zwei senkrecht zur Zeichenebene der oberen Teilfigur angeordnet sind und einer (3a) von oberhalb der Zeichenebene her in den Behälter 1 hineinragt. Die Anordnung der Stifte 3 ist insgesamt oktaedrisch, d.h. die Stiftenden sind an den Ecken einer Doppelpyramide mit quadratischer Basisfläche angeordnet. Der sechste Stift (3b) befindet sich in Gegenposition zum Stift 3a an der Unterseite des Behälters 1, siehe untere Teilfigur.

Selbstverständlich sind auch andere Konfigurationen von Stiften möglich, als einfachste z.B. eine tetraedrische mit vier Stiften, oder bei besonderen Erfordernissen polyedrische.

In dem Behälter 1, welcher sich im schwerelosen Zustand befinden soll, ist ein Kristallisationsexperiment durchzuführen. Dazu wird vor Beginn dieses Experimentes durch eine spezielle, verschließbare Öffnung 5, etwa mit Hilfe einer Spritze oder Pipette, eine Flüssigkeit in das Behälterinnere kontinuierlich eingebracht, welche sich infolge der herrschenden Schwerelosigkeit lediglich aufgrund ihrer Oberflächenspannung zu einer Flüssigkeitskugel 6 formt. Diese Flüssigkeit ist ein Lösungsmittel für die zu kristallierende Substanz, deren Konzentration in der Flüssigkeit zunächst noch unterhalb der Sättigungsgrenze liegt. Die Flüssigkeitskugel 6 wird in den Raumbereich zwischen die inneren Enden der Stifte 3 eingebracht und ihre endgültige Größe so bemessen, daß ihr Durchmesser größer ist als der Abstand der inneren Enden zweier benachbarter Stifte 3. Für diese Bemessung stehen als Variable demnach das Volumen der in den Behälter 1 eingeführten Flüssigkeit sowie die justierbare Länge des in den Behälter 1 hineinragenden Teils der Stifte 3 zur Verfügung. Die Flüssigkeitskugel 6 wird aufgrund des schwerelosen Zustandes ihre Kugelform stets nahezu vollkommen beibehalten.

Wird die Flüssigkeit sehr vorsichtig und geschickt in den Raumbereich zwischen die Stiftenden eingeführt, so wird ihr insgesamt kein Impuls mitgeteilt, so daß die Flüssigkeitskugel 6 bewegungslos zwischen den Stiftenden schwebt. Sollte die Flüssigkeitskugel 6 doch in Bewegung geraten, so wird sie durch die als Rückhalteelemente dienenden Stifte 3 daran gehindert mit den Behälterwänden in Kontakt zu geraten. Dabei wird die Flüssigkeitskugel 6 an das Ende eines der Stifte 3, möglicherweise auch an zwei oder höchstens 3 Stiftenden stoßen, wobei ihre Oberfläche dort leicht eingedellt wird. Aufgrund der quasi elastischen Wirkung, der Oberflächenspannung und der sehr geringen relativen Geschwindigkeit der Flüssigkeitskugel 6 wird letztere wieder von dem berührten Stiftende abgestoßen werden und anschließend wiederum berührungslos in dem Raumbereich zwischen den Stiftenden schweben. Die im Inneren der Flüssigkeitskugel 6 stattfindenden Prozesse können somit ungestört von äußeren Einflüssen, wie sie durch einen großflächigen Wandkontakt hervorgerufen würden, ablaufen.

Enthält die Flüssigkeitskugel 6 eine auszukristallisierende Substanz, deren Konzentration dicht unterhalb der Sättigungsgrenze liegt, so kann der Kristallisationsprozeß dadurch in Gang gesetzt werden, daß der sich im Behälterinneren außerhalb der Flüssigkeitskugel 6 aufbauende Dampfdruck mit Hilfe der Vakuumpumpe 2 ständig unterhalb des Gleichgewichtswertes gehalten wird. Dies führt dazu, daß die Lösungsmittelkonzentration innerhalb der Flüssigkeitskugel 6 abnimmt und die Konzentration der auszukristallisierenden Substanz gleichzeitig ansteigt, um schließlich den Sättigungswert zu überschreiten. Damit kann die Kristallisation beginnen. Unter diesen Bedingungen sind Einkristalle mit äußerst geringer Strukturfehleranzahl herstellbar.

Die Stifte 3 oder mindestens deren innere Enden sind zweckmäßigerweise aus einem Material herzustellen, welches von der die Flüssigkeitskugel 6 hauptsächlich bildenden Flüssigkeit nicht oder nur wenig benetzbar ist. Wird Wasser als Flüssigkeit bzw. als Lösungsmittel verwendet, so können die Stifte beispielsweise aus Teflon bestehen. Die Flüssigkeit bzw. das Lösungsmittel selbst sollte eine möglichst große Oberflächenspannung besitzen.

Mit Hilfe des erfindungsgemäßen Verfahrens können beispieisweise biochemisch relevante Verbindungen, wie Proteine, Nukleinsäuren usw. auskristallisiert werden. Experimente mit hochgereinigten Enzymen, wie niedermolekularem Lysozym und hochmolekulaler β-Galaktosidase sind damit ebenfalls durchführbar. Das Verfahren ist jedoch keinesfalls hierauf beschränkt, sondern vielmehr universell anwendbar, d.h. auch zur Auskristallisation anderer organischer sowie auch anorganischer Substanzen aus geeigneten Lösungsmitteln.

Neben dem zuvor geschilderten Unterdruckverfahren (Vakuumpumpe 2) kann eine langsame Konzentrierung einer auszukristallisierenden Substanz aus der Flüssigkeitskugel auch auf andere Arten erfolgen.

So kann der die Flüssigkeitskugel aufnehmende Behälter beispielsweise an einen weiteren Behälter angeschlossen werden, welcher lösungsmittelabsorbierendeVerbindungen enthält. Wird bei der Kristallisation etwa Wasser als Lösungsmittel verwendet, so können als absorbierende Verbindungen CaCl$_2$, P$_4$O$_{10}$, Mg(ClO$_4$)$_2$ usw. herangezogen werden. Für organische Lösungsmittel können auch oberflächenaktive Substanzen verwendet werden.

Weiterhin ist es möglich, die zu kristallisierende Substanz aus ihrer Lösungsmittelphase durch eine zweite Substanz auszudrängen. Das Ausdrängen erfolgt dabei über eine Dampffhase. Ist die auszukristallisierende Substanz beispielsweise wasserlöslich, dagegen schwer löslich in Aceton, so kann letzteres in flüssiger Phase in den Behälter eingebracht werden. Zur Fixierung dieser flüssigen Phase außerhalb des für die Flüssigkeitskugel vorgesehenen Raumbereiches kann etwa eine netzförmige Trennwand vorgesehen sein. Es bildet sich dann eine Wasserdampf und Acetondampf enthaltende Dampfphase. Aceton wird von der hauptsächlich aus Wasser bestehenden Flüssigkeitskugel, Wasserdampf vom flüssigen Aceton aufgenommen. So erfolgt in der Flüssigkeitskugel eine zunehmende Wasserverarmung, verbunden mit gleichzeitig zunehmender Acetonanreicherung. Die zu kristallisiernde Substanz wird daher langsam aus der Lösung herausgedrängt.

Eine hydrophobe Substanz kann in einem hydrophoben Lösungsmittel z.B. in Kohlenwasserstoffen, gelöst werden. Hieraus bestünde dann die Flüssigkeitskugel. Wird andererseits eine hydrophile Flüssigkeit z.B. Methanol, in flüssiger Phase in den Behälter eingeführt, so erfolgt über die Dampfphase ein Austausch von Kohlenwasserstoff und Methanol derart, daß die Flüssigkeitskugel an Methanol angereichert wird und an Kohlenwasserstoff verarmt, während die flüssige Methanolphase Kohlenwasserstoff aufnimmt. Die Methanolanreicherung in der Flüssigkeitskugel führt schließlich zur Auskristallisation der im Kohlenwasserstoff gelösten Substanz.

Weiterhin ist es möglich etwa Proteine aus wässriger Lösung durch vorsichtiges "Aussalzen" zu verdrängen. Dabei wird die die Flüssigkeitskugel bildende, wässrige Proteinlösung bis in die Nähe des Ausdrängungspunktes mit Salz, z.B. Ammoniumsulfat, gesättigt. In den Behälter wird außerdem eine wässrige Ammoniumsulfatlösung eingebracht, deren Salzkonzentration höher als jene in der Flüssigkeitskugel ist. Über die Dampfphase stellt sich allmählich ein Gleichgewicht ein, welches zur Verdünnung der wässrigen Ammoniumsulfatlösung und zur Aufkonzentration des Ammoniumsulfats in der wässrigen Proteinlösung der Flüssigkeitskugel führt. So wird der Ausdrängungspunkt des Proteins überschritten und letzteres beginnt auszukristallisieren.

Ferner können generell alle beliebigen Substanzen durch Temperaturvariation kristallin aus Lösungen ausgedrängt werden.

Das erfindungsgemäße Verfahren ist vorwiegend zum Einsatz im, Weltraum, beispielsweise im Spacelab, wo Mikrogravitationsbedingungen herrschen, geeignet. Die schwebende Flüssigkeitskugel ist nur unter diesen Bedingungen existenzfähig. Beim Rücktransport auf die Erde treten außerdem Beschleunigungen auf, welche die Gefahr der Zerstörung der gebildeten Kristalle mit sich bringen. Es ist daher zweckmäßig, noch während des schwerelosen Zustandes, jedoch nachdem die Kristalle bereits gebildet sind, den gesamten Behälter mit einer geeigneten Flüssigkeit zu fluten, in der die Kristalle dann schwimmen. So wird vermieden, daß beim Auftreten von Beschleunigungen die Flüssigkeitskugel an den Enden der Rückhalteelemente zerschlagen wird und die Kristalle eventuell an den Behälterwänden zerbrechen. Dabei sollte die zum Fluten verwendete Flüssigkeit ungefähr die gleiche Dichte wie die Kristalle besitzen, kein Lösungsmittel dafür sein, zu keinen chemischen Reaktionen mit den Kristallen fähig und nach Möglichkeit lückenlos mit der Flüssigkeit der Flüssigkeitskugel mischbar sein. Letzteres ist allerdings nicht unerläßlich. Im Falle von Proteinkristallen kann z.B. mit Ammoniumsulfatlösungen geflutet werden, deren Konzentration geringfügig über der Konzentration des Ammoniumsulfats in der Flüssigkeitskugel liegt. Die den Behälter nunmehr vollständig ausfüllende Flüssigkeit wirkt bei Beschleunigungsschocks dämpfend auf die Bewegung der Kristalle. Somit ist es möglich die Kristalle weitgehend unbeschädigt auf die Erde zu transportieren.

**Patentansprüche**

1. Verfahren zum Auskristallisieren einer Substanz, die in einer im Zustand der Schwerelosigkeit befindlichen Flüssigkeit gelöst ist, dadurch gekennzeichnet, daß die Flüssigkeit während der Auskristallisation als quasi freischwebende Flüssigkeitskugel (6) gehalten und die Substanz in der Flüssigkeit mit Hilfe an sich bekannter Methoden auskristallisiert wird.

2. Verfahren nach Anspruch 1, dadurch gekennzeichnet, daß die Flüssigkeitskugel (6) innerhalb eines bestimmten Raumbereiches schwebend gehalten wird, welcher von außen her durch mit Abstand zueinander angeordnete Rückhalteelemente (3) begrenzt wird.

3. Verfahren nach Anspruch 1 oder 2, wobei die Flüssigkeitskugel (6) innerhalb eines Behälters (1) schwebend gehalten wird, dadurch gekennzeichnet, daß nach Durchführung der Auskristallisation und noch während des schwerelosen Zustandes der Behälter (1) mit einer Flüssigkeit geflutet wird.

4. Verfahren nach Anspruch 3. dadurch gekennzeichnet, daß zum Fluten eine Flüssigkeit verwendet wird, welche etwa die gleiche Dichte wie die gebildeten Kristalle aufweist, kein Lösungsmittel für letztere darstellt und zu keinen chemischen Reaktionen mit der kristallisierten Substanz fähig ist.

5. Verfahren nach Anspruch 3 oder 4, dadurch gekennzeichnet, daß zum Fluten eine lückenlos mit der Flüssigkeit der Flüssigkeitskugel (6) mischbare Flüssigkeit verwendet wird.

6. Vorrichtung zur Durchführung des Verfahrens nach Anspruch 1 oder 2, dadurch gekennzeichnet, daß den Raumbereich von außen her punktuell oder linienförmig begrenzende mit Abstand zueinander angeordnete Rückhalteelemente (3) vorhanden sind, wobei die Abstände jeweils einander benachbarter Rückhalteelemente (3) an der Grenze des Raumbereiches kleiner sind als der Durchmesser der Flüssigkeitskugel (6).

7. Vorrichtung zur Durchführung des Verfahrens nach Anspruch 6, gekennzeichnet durch an den Innenwänden eines Behälters (1) angebrachte Rückhalteelemente (3).

8. Vorrichtung nach Anspruch 6 oder 7, gekennzeichnet durch den Raumbereich punktuell begrenzender Rückhalteelemente (3) in Form von radial auf die Mitte des Raumbereiches ausgerichteten Stiften.

9. Vorrichtung nach Anspruch 6 oder 7, gekennzeichnet durch den Raumbereich linienförmig begrenzende Rückhalteelemente in Form vom Inneren des Raumbereichs her gesehen konkav gewölbter Leisten oder Platten mit konkav gewölbten Kanten oder gitter- oder netzförmig angeordneter Fäden oder Drähte.

10. Vorrichtung nach einem der Ansprüche 6 bis 9, dadurch gekennzeichnet, daß die Rückhalteelemente (3) zumindest an ihren dem Raumbereich zugekehrten Seiten aus einem durch die Flüssigkeit nicht oder nur wenig benetzbaren Material hergestellt sind.

**Claims**

1. A method of crystallising out a substance which is dissolved in a liquid which is in the condition of weightlessness, **characterised in that** the liquid is kept during crystallising out as a quasi freely hovering ball of liquid (6) and the substance in the liquid is crystallised out with the aid of techniques known per se.

2. A method according to claim 1, **characterised in that** the ball of liquid (6) is kept hovering within a certain area of space which is limited from outside by retaining elements (3) arranged at a spacing from each other.

3. A method according to claim 1 or 2, in which the ball of liquid (6) is kept hovering within a container (1) **characterised in that** after carrying out crystallising out and still during the weightless condition the container (1) is flooded with a liquid.

4. A method according to claim 3, **characterised in that** for flooding a liquid is used which has approximately the same density as the crystals formed, does not represent a solvent for the latter and is not capable of any chemical reactions with the crystallised substance.

5. A method according to claim 3 or 4, **characterised in that** for flooding, a liquid is used which is miscible without voids with the liquid of the ball of liquid (6).

6. A device for carrying out the method according to claim 1 or 2, **characterised in that** retaining elements (3) are present which are arranged at a spacing from each other and which limit the area of space from outside by points or lines, in which the spacings of adjoining retaining elements (3) respectively at the limit of the area of space are smaller than the diameter of the ball of liquid (6).

7. A device for carrying out the method, according to claim 6, **characterised by** retaining elements (3) arranged on the inner walls of a container (1).

8. A device according to claim 6 or 7, **characterized by** the retaining elements (3) limiting the area of space by points, in the form of pins aligned radially to the centre of the area of space.

9. A device according to claim 6 or 7, **characterized by** retaining elements limiting the area of space by lines, in the form of, as seen from the inside of the area of space concave borders or plates having concave edges or lattic- or network-shaped threads or wires.

10. A device according to any one of claims 6 to 9, **characterized in that** the retaining elements(3) are manufactured at least on their sides facing the area of space from a material which cannot or can only slightly be wetted by the liquid.

**Revendications**

1. Procédé de cristallisation d'une substance dissoute dans un liquide se trouvant en état d'apesanteur, caractérisé en ce que le liquide est maintenu pendant la cristallisation comme une sphère de liquide (6) flottant presque librement et en ce que la substance cristallise dans le liquide à l'aide de méthodes connues en soi.

2. Procédé selon la revendication 1, caractérisé en ce que la sphère de liquide (6) est maintenue flottante à l'intérieur d'une zone d'espace déterminée, qui est limitée de l'extérieur par des éléments de soutien (3) placés à une certaine distance les uns des autres.

3. Procédé selon l'une des revendications 1 ou 2, dans lequel la sphère de liquide (6) est maintenue flottante à l'intérieur d'un récipient (1), caractérisé en ce qu'après la réalisation de la cristallisation et toujours pendant l'état d'apesanteur, le récipient (1) se trouve rempli de liquide.

4. Procédé selon la revendication 3, caractérisé en ce que pour le remplissage, on utilise un liquide, qui comporte environ la même densité que les cristaux formés, n'est pas un solvant pour ces derniers et n'est pas apte à réagir chimiquement avec la substance cristallisée.

5. Procédé selon l'une des revendications 3 ou 4, caractérisé en ce que pour le remplissage, on utilise un liquide miscible complètement avec le liquide de la sphère de liquide (6).

6. Dispositif pour réalisation du procédé selon l'une des revendications 1 ou 2, caractérisé en ce qu'il existe des éléments de soutien (3) placés à une certaine distance les uns des autres, délimitant la zone d'espace de l'extérieur ponctuellement ou par lignes, les distances respectives entre éléments voisins les uns des autres étant plus petites que le diamètre de la sphère de liquide (6).

7. Dispositif pour exécution du procédé selon la revendication 6, caractérisé par des éléments de soutien fixés sur les parois intérieures d'un récipient (1).

8. Dispositif selon l'une des revendications 6 ou 7, caractérisé par des éléments de soutien (3) délimitant ponctuellement la zone d'espace sous la forme de broches dirigées radialement vers le centre de la zone d'espace.

9. Dispositif selon l'une des revendications 6 ou 7, caractérisé par des éléments de soutien délimitant la zone d'espace par des lignes sous la forme de barrettes courbées de façon concave ou de plaques avec des bords courbés de façon concave, en regardant depuis l'intérieur de la zone d'espace ou bien encore de fibres ou fils disposés en grille ou en réseau.

10. Dispositif selon l'une des revendications 6 à 9, caractérisé en ce que les éléments de soutien (3) au moins sur leurs faces tournées vers la zone d'espace sont fabriqués avec un matériau pas ou seulement peu mouillables par le liquide.